# EUROPÄISCHE PATENTSCHRIFT

(11) **EP 1 696 477 B1**
(45) Veröffentlichungstag und Bekanntmachung des Hinweises auf die Patenterteilung: **02.09.2009**
(21) Anmeldenummer: 06101288.6
(22) Anmeldetag: 03.02.2006
(51) Int. Cl.: H01L 21/308, H01L 21/033

(54) **Verfahren zur Herstellung von sublithographischen Strukturen**
Process of fabrication of sub-lithographic structures
Procédé de fabrication de structures sub-lithographiques

(30) Priorität: 24.02.2005 DE 102005008478
(43) Veröffentlichungstag der Anmeldung: 30.08.2006
(73) Patentinhaber: Infineon Technologies AG, 81669 München (DE)
(72) Erfinder: Gutsche, Martin, 84405 Dorfen (DE); Seidl, Harald, 85604 Pöring (DE)
(74) Vertreter: Kindermann, Peter

(56) Entgegenhaltungen:
- DE-A1- 4 446 852
- US-A- 4 354 896
- US-A1- 2006 060 562

## Beschreibung

Die vorliegende Erfindung bezieht sich auf ein Verfahren zur Herstellung von sublithographischen Strukturen und insbesondere von sublithographischen Strukturen, welche zueinander einen sublithographischen Abstand aufweisen.

Bei der Entwicklung von geeigneten Lithographieverfahren zur Herstellung sehr feiner Strukturen beispielsweise unterhalb von 100 nm ergeben sich außerordentlich große Probleme, die insbesondere aus der sogenannten Resistchemie, der Maskenherstellung und der Komplexität des Lithographiesystems resultieren.

Bei der Weiterentwicklung der optischen Lithographie zur Herstellung von sehr feinen Strukturen in einem Bereich kleiner 100 nm wurde die sogenannte 157 nm-Lithographie erreicht. Diese Lithographieverfahren benötigen hierbei neuartige Resistmaterialien, wobei trotz intensivster Bemühungen bisher kein Resist gefunden wurde, der vollständig die technischen Anforderungen hinsichtlich derartig kleiner Strukturen erfüllt. Darüber hinaus sind neben diesen neuen Materialien auch neue Verfahren zur Maskenherstellung notwendig, wobei deren Entwicklung wiederum sehr kostenintensiv ist. Es ergeben sich daher sehr kostenintensive und schwer handhabbare Lithographiesysteme.

Als Alternative zu derartigen herkömmlichen optischen Lithographieverfahren wurden daher sogenannte sublithographische Verfahren eingeführt. Bei diesen Verfahren wird z.B. mit einem herkömmlichen Fotoresist eine Struktur auf einer Hilfsschicht fotolithographisch ausgebildet, die Hilfsschicht unter Verwendung des strukturierten Fotoresists anisotrop geätzt, die Resistmaske entfernt, und anschließend wird mittels eines isotropen Ätzverfahrens die Hilfsschicht von allen Seiten nochmals zurückgeätzt und damit verkleinert. Auf diese Weise erhält man sublithographische Maskenstrukturen, die mit üblichen Ätzverfahren zur Ausbildung von beispielsweise sublithographischen Gatestrukturen in eine Gateschicht übertragen werden können.

In gleicher Weise können derartige sublithographische Maskenstrukturen auch mittels des sogenannten Spacerverfahrens ausgebildet werden, wobei üblicherweise mittels optischer Lithographie zunächst eine erste Maske mit im Wesentlichen senkrechten Seitenwänden ausgebildet und strukturiert wird. Anschließend wird eine sehr dünne weitere Maskenschicht ganzflächig an der Oberfläche der ersten Maske bis zu einer vorbestimmten Dicke abgeschieden. Mittels eines anisotropen Ätzverfahrens werden anschließend die horizontalen Schichtbereiche der weiteren Maskenschicht entfernt, so dass nur noch eine sublithographische Maskenstruktur an der Seitenwand der ersten Maske übrig bleibt.

Abschließend wird die erste Maske entfernt und die alleinstehenden sublithographischen Maskenstrukturen mit ihrer vorbestimmten Dicke bzw. Gatelänge in die darunter liegende Gateschicht zur Ausbildung von beispielsweise einer sublithographischen Gatestruktur übertragen.

Aus der Druckschrift US-A-4 354 896 ist ein Verfahren zur Herstellung von sublithographischen Strukturen bekannt, wobei nach dem Vorbereiten einer Trägerschicht eine ganzflächige erste Hilfsschicht an der Oberfläche der Trägerschicht und eine lithographisch strukturierte zweite Hilfsschichtstruktur an der Oberfläche der ersten Hilfsschicht ausgebildet wird. Unter Verwendung der strukturierten zweiten Hilfsschichtstruktur als Maske wird die erste Hilfsschicht bis zur Trägerschicht zum Ausbilden einer ersten Hilfsschichtstruktur anisotrop geätzt. Ferner erfolgt ein isotropes Rückätzen der ersten Hilfsschichtstruktur unter Verwendung der zweiten Hilfsschichtstruktur, wodurch Teilabschnitte unterhalb der zweiten Hilfsschichtstruktur entfernt und eine isotrop strukturierte erste Hilfsschichtstruktur ausgebildet werden. Nachfolgend wird auch an den Teilabschnitten unterhalb der zweiten Hilfsschichtstruktur eine ganzflächige Maskenschicht ausgebildet und anisotrop bis zur Trägerschicht geätzt, wodurch sublithographische Strukturen ausgebildet werden, die schließlich durch Entfernen der ersten und zweiten Hilfsschichtstruktur freigelegt werden.

Ferner ist aus der Druckschrift DE 44 46 852 A1 ein Verfahren zur Bildung einer Mikrostruktur bei einer Halbleitervorrichtung bekannt, wobei zumindest zwei lithographisch ausgebildete Hilfsschichtstrukturen seitlich unterätzt und mit Photolack aufgefüllt werden, um sublithographische Strukturen zu schaffen.

Nachteilig bei derartigen herkömmlichen Verfahren ist jedoch, dass auf diese Art und Weise zwar sublithographische Strukturen erzeugt werden können, jedoch deren minimaler Abstand voneinander weiterhin vom lithographischen System bestimmt wird und insbesondere größer als eine minimale mittels Lithographie erzeugbare Strukturgröße F ist. Genauer gesagt ist bei derartigen herkömmlichen Verfahren weiterhin ein sogenannter "Pitch", der sich zusammensetzt aus der Summe einer Strukturbreite und einem Abstand von unmittelbar benachbarten Strukturen, weiterhin 2F, d.h. der doppelten minimalen mittels Lithographie erzeugbaren Strukturgröße.

Der Erfindung liegt daher die Aufgabe zu Grunde ein Verfahren zur Herstellung von sublithographischen Strukturen zu schaffen, bei dem auch ein Abstand zwischen benachbarten Strukturen unabhängig vom lithographischen System ist und insbesondere sublithographische Ausmaße aufweist.

Erfindungsgemäß wird diese Aufgabe durch die Maßnahmen des Patentanspruchs 1 gelöst.

Demzufolge wird an der Oberfläche einer Trägerschicht eine erste Hilfsschicht ganzflächig ausgebildet, und anschließend an der Oberfläche der ersten Hilfsschicht eine lithographisch strukturierte zweite Hilfsschichtstruktur ausgebildet.

Erfindungsgemäß wird als zweite Hilfsschichtstruktur eine zweite Hilfsschicht zunächst ganzflächig ausgebildet und zum Ausbilden von zumindest zwei lithographischen Hilfsschichtstrukturen lithographisch strukturiert. Über diesen lithographisch strukturierten Hilfsschichtstrukturen wird ferner eine Spacerschicht ganzflächig ausgebildet und zum Ausbilden einer Spacerstruktur an den Seitenwänden der Hilfsschichtstrukturen mittels eines Spacerverfahrens durch anisotropes Rückätzen strukturiert. Durch dieses zweifache Verfahren können die Abmessungen der zweiten Hilfsschichtstruktur sehr genau eingestellt werden. Ferner wird zunächst ein anisotropes Rückätzen der ersten Hilfsschicht unter Verwendung der zweiten Hilfsschichtstruktur als Maske bis zur Trägerschicht und anschließend ein isotropes Rückätzen zum Entfernen von Teilabschnitten unterhalb der ersten Hilfsschichtstruktur durchgeführt.
In einem nachfolgenden Schritt wird die eigentliche Maskenschicht ganzflächig und insbesondere auch an den Teilabschnitten unterhalb der ersten Hilfsschichtstruktur ausgebildet, und anschließend ein weiteres anisotropes Rückätzen dieser Maskenschicht zum Ausbilden der sublithographischen Struktur durchgeführt. Nach dem Entfernen der ersten und zweiten Hilfsschichtstrukturen wird die sublithographische Struktur freigelegt, wobei nicht nur eine Breite sondern auch ein Abstand zwischen benachbarten Strukturen eine sublithographische Abmessung aufweist. Insbesondere bei der Herstellung von Speicher-Arrays ergeben sich dadurch bei verringerten Kosten bisher nicht gekannte Integrationsdichten.

Vorzugsweise wird beim Ausbilden der zweiten Hilfsschichtstruktur ein Abstand zwischen zwei benachbarten zweiten Hilfsschichtstrukturen durch die Spacerstruktur auf eine halbe Breite der lithographisch strukturierten Hilfsschichtstruktur und eine Breite der Teilabschnitte unterhalb der zweiten Hilfsschichtstruktur ebenfalls auf eine halbe Breite der lithographischen Hilfsschichtstruktur eingestellt. Auf diese Weise erhält man einen symmetrischen Aufbau, d.h. eine Breite der sublithographischen Strukturen ist gleich dem Abstand zwischen zwei benachbarten sublithographischen Strukturen. Wird als Strukturbreite der lithographisch strukturierten Hilfsschichtstrukturen eine minimale mittels Lithographie erzeugbare Strukturgröße F verwendet, so ergibt sich demzufolge sowohl für den Abstand als auch für die sublithographische Struktur eine Breite von 0,5 F, wodurch der sogenannte Pitch (= Strukturgröße + Abstand) einen Wert von F aufweist.

Vorzugsweise wird eine Dicke der ersten Hilfsschicht auf 1/5 der Breite der lithographischen Hilfsschichtstruktur eingestellt, wodurch in einem nachfolgenden Verfahrensschritt die Maskenschicht lunkerfrei, d.h. ohne Hohlräume oder Öffnungen, ausgebildet werden kann.

Vorzugsweise wird als Trägerschicht Si, als erste Hilfsschicht SiGe, C oder SILK, als zweite Hilfsschichtstruktur SiN und als Maskenschicht SiO₂ verwendet. Alternativ kann für die Trägerschicht auch SiO₂ und als Maskenschicht Si verwendet werden, wobei die übrigen Schichten gleich bleiben. Bei Verwendung derartiger Materialien ergibt sich ein besonders einfaches Herstellungsverfahren, da es sich um Standardmaterialien der Halbleitertechnik handelt.

Zum Ätzen der SiGe-Hilfsschichtstruktur kann entweder HNO₃/HF/CH₃COOH/H₂O oder H₂O₂ oder NH₄OH/H₂O₂/H₂O als Ätzmittel verwendet werden. Zum Ätzen der zweiten Hilfsschichtstruktur wird vorzugsweise heiße Phosphorsäure (H₃PO₄) mit einer Temperatur von beispielsweise 150 Grad Celsius als Ätzmittel verwendet.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahme auf die Zeichnung näher beschrieben.

Es zeigen:

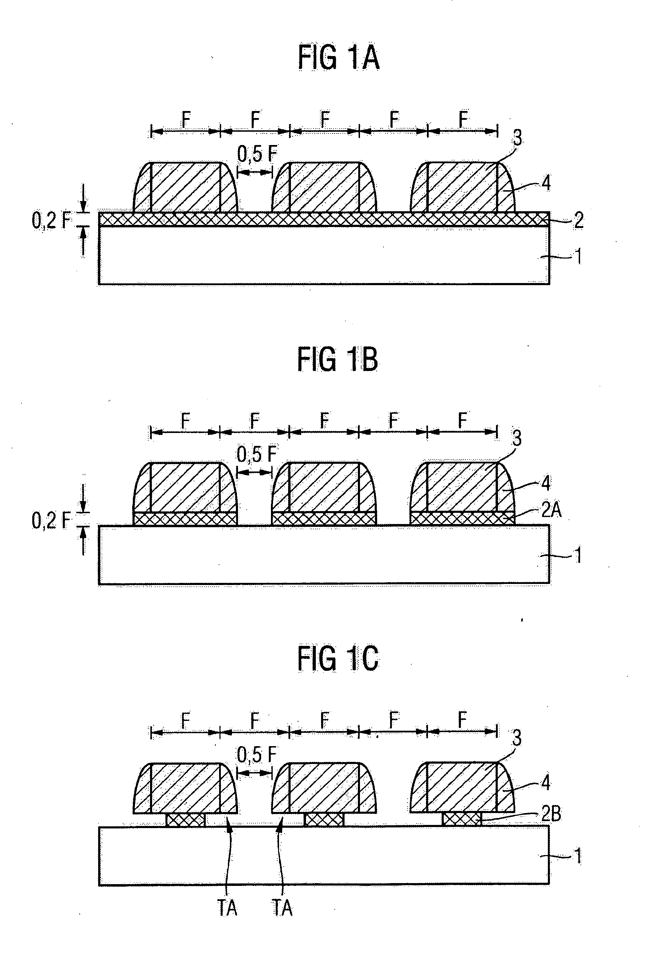

Figuren 1A bis 1F vereinfachte Schnittansichten zur Veranschaulichung wesentlicher Verfahrensschritte bei der Herstellung von sublithographischen Strukturen gemäß einem ersten und zweiten Ausführungsbeispiel.

Anhand der Figuren 1A bis 1F werden nachfolgend zwei bevorzugte Ausführungsbeispiele beschrieben, die sich im Wesentlichen in der Auswahl ihrer jeweiligen Materialien voneinander unterscheiden.

### Erstes Ausführungsbeispiel

Gemäß Figur 1A wird zunächst eine Trägerschicht 1 vorbereitet. Hierbei kann es sich unmittelbar um ein Trägersubstrat handeln wie beispielsweise einen Halbleiterwafer oder um eine auf einem nicht dargestellten Trägersubstrat ausgebildete Trägerschicht 1. Gemäß dem ersten Ausführungsbeispiel wird auf einem Silizium-Halbleiterwafer eine Si-Schicht 1 als zu strukturierende Trägerschicht abgeschieden. Anschließend wird eine SiGe-Schicht als erste Hilfsschicht 2 mit einer Dicke kleiner 0,5 F ausgebildet, wobei F eine minimale mittels Lithographie erzeugbare Strukturgröße der Fertigungslinie darstellt. Vorzugsweise ist die Schichtdicke der ersten Hilfsschicht 2 kleiner 0,25 F oder sogar kleiner 0,2 F, wodurch für eine spätere Abscheidung eine ausreichende Lunkerfreiheit sichergestellt werden kann.

Alternativ kann als erste Hilfsschicht 2 auch eine Kohlenstoff-Schicht, SILK™ oder andere Materialien mit geeigneten Ätzselektivitäten verwendet werden. SILK™ stellt hierbei ein organisches Spin-on-Polymer mit idealen Fülleigenschaften und guten Planarisierungseigenschaften dar, welches eine Temperaturstabilität von bis zu 450 Grad Celsius aufweist und unter diesem Namen von der Firma Dow Chemical vertrieben wird.

Als Abscheideverfahren für die erste Hilfsschicht 2 wird vorzugsweise ein CVD-Verfahren durchgeführt, mit dem die erste Hilfsschicht 2 mit im Wesentlichen gleicher Schichtdicke, d.h. konformal an der Oberfläche der vorzugsweise planaren Trägerschicht 1 ausgebildet wird. Grundsätzlich sind jedoch auch Sputter-, (PVD, Physical Vapor Deposition) oder sonstige Verfahren denkbar, mit denen eine derartige Schicht mit gut einstellbarer Schichtdicke ausgebildet werden kann.

Anschließend werden lithographisch strukturierte zweite Hilfsschichtstrukturen an der Oberfläche der ersten Hilfsschicht 2 ausgebildet. Die Abmessungen dieser zweiten Hilfsschichtstrukturen werden im wesentlichen durch fotolithographische Prozesse festgelegt.

Gemäß dem ersten Ausführungsbeispiel wird hierfür eine zweite Hilfsschicht ganzflächig an der Oberfläche der ersten Hilfsschicht 2 beispielsweise mittels eines CVD-Verfahrens abgeschieden. Als bevorzugtes Material wird hierbei z.B. SiN bzw. Si₃N₄ verwendet. Anschließend wird zum Ausbilden von lithographischen Hilfsschichtstrukturen 3 eine lithographische Strukturierung der zweiten Hilfsschicht durchgeführt. Genauer gesagt erfolgt eine Lithographie und Ätzung der zweiten Hilfsschicht bis zur ersten Hilfsschicht 2, so dass sich Linien und dazwischen liegende Abstände mit einem Pitch von 2 F einstellen, wobei F wiederum die minimale mittels Lithographie erzeugbare Strukturgröße darstellt.

Nach diesem Ausbilden der lithographischen Hilfsschichtstrukturen 3 mit ihrer Strukturbreite F und dem zwischen den Strukturen liegenden Abstand von ebenfalls F wird nunmehr eine Spacerstruktur 4 an den Seitenwänden der lithographischen Hilfsschichtstrukturen 3 zur Vervollständigung der zweiten Hilfsschichtstruktur ausgebildet. Genauer gesagt wird an der Oberfläche der lithographischen Hilfsschichtstrukturen 3 und der ersten Hilfsschicht 2 eine gleichmäßig dicke Spacerschicht ganzflächig ausgebildet und mittels eines Spacerverfahrens, d.h. anisotrop derart rückgeätzt, dass die in Figur 1A dargestellte Spacerstruktur 4 entsteht.

Vorzugsweise wird für die Spacerschicht bzw. die Spacerstruktur 4 das gleiche Material verwendet wie für die lithographischen Hilfsschichtstrukturen 3, wobei im vorliegenden Ausführungsbeispiel SiN verwendet wird. Die Dicke der Spacerschicht bestimmt im Wesentlichen einen Abstand zwischen zwei benachbarten Seiten der Hilfsschichtstrukturen und sollte zur Realisierung einer symmetrischen sublithographischen Struktur, bei der eine Strukturbreite gleich einem Abstand zwischen zwei Strukturen ist, 1/4 der Breite der lithographischen Hilfsschichtstrukturen 3 sein. Zur Realisierung von minimalen Strukturbreiten mit minimalen Abständen wird daher die Dicke der Spacerschicht auf F/4 eingestellt.

Gemäß Figur 1B wird nunmehr ein anisotropes Rückätzen der ersten Hilfsschicht 2 unter Verwendung der strukturierten zweiten Hilfsschichtstruktur, die aus den lithographischen Hilfsschichtstrukturen 3 und der Spacerstruktur 4 besteht, als Maske bis zur Trägerschicht 1 durchgeführt. Auf diese Weise erhält man eine anisotrop strukturierte erste Hilfsschichtstruktur 2A, welche im Wesentlichen die gleiche Breite aufweist wie die zweite Hilfsschichtstruktur 3 und 4. Vorzugsweise wird hierbei insbesondere für SiGe und C ein RIE-Trockenätzverfahren durchgeführt. SiGe kann hierbei mit Fluor, Chlor oder Bromchemie geätzt werden. Bei Verwendung eines CF₄-Plasmas kann SiGe z.B. mit einer Plasmaenergie von 700 W und einem Druck von ca. 46 Pa (350 mT) geätzt werden. Für Kohlenstoff als erste Hilfsschicht 2 wird beispielsweise O₂-Plasma werwendet.

Gemäß Figur 1C wird nunmehr ein isotropes Rückätzen der anisotrop strukturierten ersten Hilfsschichtstruktur 2A wiederum unter Verwendung der strukturierten zweiten Hilfsschichtstruktur 3 und 4 zum Entfernen von Teilabschnitten TA seitlich unterhalb der zweiten Hilfsschichtstruktur durchgeführt. Auf diese Weise wird eine isotrop strukturierte erste Hilfsschichtstruktur 2B ausgebildet, deren Strukturbreite bereits sublithographisch ist und beispielsweise auf eine Strukturbreite von F/2 eingestellt wird. Dieses isotrope, d.h. ungerichtete, Ätzverfahren ist wiederum selektiv zu der Trägerschicht 1 bzw. zu Si und zu der zweiten Hilfsschichtstruktur bzw. zu SiN. Für dieses isotrope Rückätzen sind verschiedene Varianten denkbar.

Gemäß einer Variante 1 wird als Ätzchemie eine nasschemische Ätze verwendet, welche mit H₂O verdünnt ist. Ein typisches Mischungsverhältnis liegt hierbei bei 10:1 und bei 10:5. Als Ätzmittel wird HNO₃ (70%/HF) (49%/CH₃COOH) (99,9%/H₂O) verwendet. Die Prozentzahlen bezeichnen hierbei Gewichtsprozente in Wasser. Ein zu verwendendes Volumenverhältnis für diese Ätze liegt z.B. bei 40/1/2/57. Weitergehende Details für dieses isotrope Rückätzen sind der Literaturstelle Lee et al.: "A Novel Multibridge-Channel MOSFET (MBCFET): Fabrication Technologies and Characteristics", IEEE Transactions on Nanotechnology, Volume 2, No. 4, Dezember 2003, Seiten 253 bis 257 zu entnehmen.

Gemäß einer Variante 2 wird als Ätzchemie H₂O₂ (30%) bei einer Temperatur von 90 Grad Celsius verwendet, wobei die Prozentzahl wiederum ein Gewichtsprozent in Wasser bedeutet. Diese Variante ist insbesondere für eine SiGe-Hilfsschicht 2 mit einem hohen Ge-Anteil > 60% geeignet. Nähere Details hierzu sind beispielsweise der Literaturstelle A. Franke et al.: "Polycrystalline Silicon-Germanium Films for Integrated Microsystems", Journal of Microelectromechanical Systems, Volume 12, No. 2, April 2003, Seiten 160 bis 171 zu entnehmen.

Gemäß einer Variante 3 wird als Ätzchemie bzw. Ätzmittel NH₄OH (30%) / H₂O₂ (30%) / H₂O bei einem Volumenverhältnis von 1/1/5 bei einer Temperatur von 75 Grad Celsius verwendet. Weitergehende Details zu dieser dritten Variante sind der Literaturstelle F. Scott Johnson et al.: "Selective Chemical Etching of Polycrystalline SiGe Alloys with Respect to Si and SiO2", J. Electron. Mater., Volume 21, No. 8, Seiten 805 bis 810, 1992 zu entnehmen. Beispielsweise ergibt sich bei dieser dritten Variante für einen Ge-Anteil von 40% eine Ätz-Selektivität von SiGe:Si = 36:1 und für SiGe:SiO₂ = 100:1. Für einen Ge-Anteil von etwa 55% ergibt sich eine Ätzselektivität für SiGe:Si = 177:1 und für SiGe:SiO₂ = 487:1.

Mit diesen nasschemischen Ätzverfahren lassen sich demzufolge Selektivitäten von grösser 100:1 für SiGe:Si, Si₃N₄ und SiO₂ erreichen.

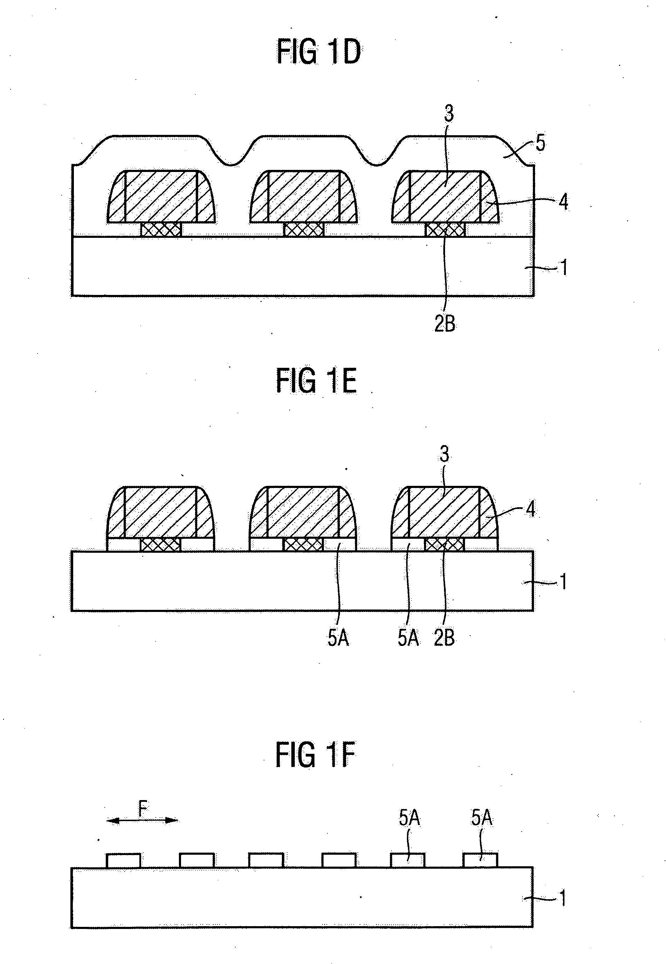

Gemäß Figur 1D wird nunmehr eine ganzflächige Maskenschicht 5 an der Oberfläche der Trägerschicht 1 der isotrop strukturierten ersten Hilfsschichtstruktur 2B und der zweiten Hilfsschichtstruktur 3 und 4 ausgebildet, wobei insbesondere auch an den Teilabschnitten TA unterhalb der ersten Hilfsschichtstruktur diese Maskenschicht 5 ausgebildet wird. Vorzugsweise wird eine konformale, d.h. gleich dicke Abscheidung mittels eines CVD-Verfahrens (Chemical Vapor Deposition) oder einem ALD-Verfahren (Atomic Layer Deposition) durchgeführt, wobei eine Schichtdicke größer ½ der Dicke der ersten Hilfsschicht 2 sein muss damit die Teilabschnitte TA seitlich unterhalb der zweiten Hilfsschichtstruktur vollständig aufgefüllt werden. Vorzugsweise sollte die Schichtdicke größer als der halbe Abstand zwischen zwei benachbarten zweiten Hilfsschichtstrukturen sein um die Bereiche zwischen den zweiten Hilfsschichtstrukturen vollständig aufzufüllen.

Gemäß diesem ersten Ausführungsbeispiel wird SiO₂ als Material für die Maskenschicht 5 abgeschieden, wodurch die Teilabschnitte TA seitlich unterhalb der zweiten Hilfsschichtstruktur vollständig und lunkerfrei aufgefüllt werden können.

Nach diesem Ausbilden der ganzflächigen Maskenschicht 5 kann ein optionales und daher nicht dargestelltes Planarisieren der Maskenschicht 5 mittels beispielsweise eines CMP-Verfahrens (Chemical Mechanical Polishing) bis zur Oberfläche der zweiten Hilfsschichtstruktur 3 und 4 durchgeführt werden.

Im Normalfall kann gemäß Figur 1E jedoch auch ohne diese optionale Planarisierung anschließend ein weiteres anisotropes Rückätzen der Maskenschicht 5 zum Ausbilden der sublithographischen Struktur 5A durchgeführt werden, welche nunmehr eine sublithographische Strukturbreite und insbesondere erstmalig auch einen sublithographischen Abstand voneinander aufweisen. Für dieses anisotrope Rückätzen der SiO₂-Maskenschicht 5 wird beispielsweise ein RIE-Trockenätzverfahren (Reactive Ion Etch) verwendet.

Abschließend werden die ersten und zweiten Hilfsschichtstrukturen 2B, 3 und 4 entfernt, wobei zum Entfernen der SiN-Hilfsschichtstruktur 3 und 4 selektiv zum SiO₂, zum Si und zum SiGe eine heiße Phosphorsäure (H₃PO₄) bei einer Temperatur von 150 Grad Celsius verwendet wird. Zum Entfernen der verbleibenden SiGe-Hilfsschicht 2B selektiv zum SiO₂ der Maskenschicht 5 und zum Si der Trägerschicht 1 können wiederum die vorstehend genannten Ätzmittel gemäß Varianten 1 bis 3 verwendet werden. Auf diese Weise erhält man die in Figur 1F dargestellten sublithographischen Strukturen, welche voneinander erstmalig einen sublithographischen Abstand aufweisen, weshalb ihr Pitch, d.h. Strukturbreite + Strukturabstand erstmalig kleiner 2 F und insbesondere bis auf 1 F reduziert werden kann.

Darüber hinaus können mit dem vorstehend beschriebenen Verfahren jedoch nicht nur Strukturbreiten und Strukturabstände mit einer Dimension von F/2 ausgebildet werden, sondern auch beliebige größere Werte, wobei lediglich eine Strukturbreite der lithographischen Hilfsschichtstruktur 3 entsprechend lithographisch vergrößert werden muss.

Eine Übertragung der sublithographischen Strukturen in die darunter liegende Trägerschicht 1 kann anschließend mit den Verfahren gemäß dem Stand der Technik durchgeführt werden.

### Zweites Ausführungsbeispiel

Gemäß einem zweiten Ausführungsbeispiel wird als zu strukturierende Schicht bzw. als Trägerschicht 1 SiO₂ verwendet und als Maskenschicht 5 Si. Die weiteren Verfahrensschritte sind hierbei identisch mit den Verfahrensschritten gemäß dem ersten Ausführungsbeispiel, weshalb auf eine wiederholte Beschreibung nachfolgend verzichtet wird.

Da als Trägerschicht 1 eine SiO₂-Schicht verwendet wird, erhält man als Ergebnis eine sogenannte Doppel-Hartmaskenschicht. Bei der konformalen Abscheidung der Maskenschicht 5 wird vorzugsweise amorphes Silizium mittels eines CVD-Verfahrens abgeschieden, wodurch die Teilabschnitte TA gemäß Figur 1C bzw. 1D besonders gut und lunkerfrei aufgefüllt werden können.

Der Vorteil dieses Ausführungsbeispiels ist darin zu sehen, dass Silizium im Gegensatz zu SiO₂ besser selektiv ätzbar ist und daher die Strukturen noch genauer bzw. exakter realisiert werden können. Im Ergebnis erhält man gemäß diesem zweiten Ausführungsbeispiel im Verfahrensschritt gemäß Figur 1F eine SiO₂-Trägerschicht 1, an deren Oberfläche die sublithographischen Si-Strukturen 5A ausgebildet sind.

Die Erfindung wurde vorstehend anhand von SiGe als erste Hilfsschicht beschrieben, wobei in gleicher Weise auch C oder SILK™ oder andere Materialien als erste Hilfsschichten verwendet werden können. In gleicher Weise können auch die weiteren Materialien durch alternative Materialien mit entsprechenden Ätzselektivitäten ersetzt werden.

## Patentansprüche

1. Verfahren zur Herstellung von sublithographischen Strukturen mit den Schritten:
a) Vorbereiten einer Trägerschicht (1);
b) Ausbilden einer ganzflächigen ersten Hilfsschicht (2) an der Oberfläche der Trägerschicht (1);
c) Ausbilden einer lithographisch strukturierten zweiten Hilfsschichtstruktur (3, 4) an der Oberfläche der ersten Hilfsschicht (2);
d) anisotropes Ätzen der ersten Hilfsschicht (2) unter Verwendung der strukturierten zweiten Hilfsschichtstruktur (3, 4) als Maske bis zur Trägerschicht (1) zum Ausbilden einer anisotrop strukturierten ersten Hilfsschichtstruktur (2A);
e) isotropes Rückätzen der anisotrop strukturierten ersten Hilfsschichtstruktur (2A) unter Verwendung der strukturierten zweiten Hilfsschichtstruktur (3, 4) zum Entfernen von Teilabschnitten (TA) unterhalb der zweiten Hilfsschichtstruktur (3, 4) und zum Ausbilden einer isotrop strukturierten ersten Hilfsschichtstruktur (2B);
f) Ausbilden einer ganzflächigen Maskenschicht (5) auch an den Teilabschnitten (TA) unterhalb der zweiten Hilfsschichtstruktur (3, 4);
g) anisotropes Ätzen der Maskenschicht (5) bis zur Trägerschicht (1) zum Ausbilden der sublithographischen Strukturen (5A); und
h) Entfernen der ersten und zweiten Hilfsschichtstruktur (2B, 3, 4) zum Freilegen der sublithographischen Strukturen (5A),
**dadurch gekennzeichnet, dass**
in Schritt c) als zweite Hilfsschichtstruktur (3, 4) eine zweite Hilfsschicht ganzflächig ausgebildet und zum Ausbilden von zumindest zwei lithographischen Hilfsschichtstrukturen (3) lithographisch strukturiert wird, und
eine Spacerschicht ganzflächig ausgebildet und zum Ausbilden einer Spacerstruktur (4) mittels eines Spacerverfahrens durch anisotropes Rückätzen strukturiert wird.

2. Verfahren nach Patentanspruch 1,
**dadurch gekennzeichnet, dass**
in Schritt c) ein Abstand zwischen zwei benachbarten zweiten Hilfsschichtstrukturen (3, 4) durch die Spacerstruktur (4) auf eine halbe Breite der lithographischen Hilfsschichtstruktur (3) eingestellt wird, und
in Schritt e) eine Breite der Teilabschnitte (TA) ebenfalls auf eine halbe Breite der lithographischen Hilfsschichtstruktur (3) eingestellt wird.

3. Verfahren nach Patentanspruch 2,
**dadurch gekennzeichnet, dass**
in Schritt b) eine Dicke der ersten Hilfsschicht (2) kleiner 1/4 der jeweiligen Breite der zumindest zwei lithographischen Hilfsschichtstrukturen (3) eingestellt wird.

4. Verfahren nach einem der Patentansprüche 1 bis 3,
**dadurch gekennzeichnet, dass**
als Trägerschicht (1) Si;
als erste Hilfsschicht (2) SiGe, C oder SILK™ , welches ein organisches Spin-on Polymer ist;
als zweite Hilfsschichtstruktur (3, 4) SiN; und
als Maskenschicht (5) SiO₂ verwendet wird.

5. Verfahren nach einem der Patentansprüche 1 bis 3,
**dadurch gekennzeichnet, dass**
als Trägerschicht (1) SiO₂;
als erste Hilfsschicht (2) SiGe, C oder SILK™ , welches ein organisches Spin-on Polymer ist;
als zweite Hilfsschichtstruktur (3, 4) SiN; und
als Maskenschicht (5) Si verwendet wird.

6. Verfahren nach einem der Patentansprüche 4 oder 5,
**dadurch gekennzeichnet, dass**
als erste Hilfsschicht (2) SiGe verwendet wird und in den Schritten e) und h) die erste Hilfsschicht (2) mit HNO₃/HF/CH₃COH/H₂O oder H₂O₂ oder NH₄OH/H₂O₂/H₂O als Ätzmittel entfernt wird; und
in Schritt h) die zweite Hilfsschichtstruktur mit H₃PO₄ als Ätzmittel entfernt wird.

7. Verfahren nach einem der Patentansprüche 1 bis 6,
**dadurch gekennzeichnet, dass**
die jeweilige Breite der zumindest zwei lithographischen Hilfsschichtstrukturen (3) eine minimale mittels Lithographie erzeugbare Strukturgröße (F) aufweist.

## Claims

1. Process for producing sublithographic structures, comprising the steps of:
a) preparing a carrier layer (1);
b) forming a first auxiliary layer (2) over the entire surface of the carrier layer (1);
c) forming a lithographically patterned second auxiliary layer structure (3, 4) on the surface of the first auxiliary layer (2);
d) anisotropically etching the first auxiliary layer (2) using the patterned second auxiliary layer structure (3, 4) as mask, down to the carrier layer (1), in order to form an anisotropically patterned first auxiliary layer structure (2A);
e) isotropically etching back the anisotropically patterned first auxiliary layer structure (2A) using the patterned second auxiliary layer structure (3, 4) to remove subsections (TA) below the second auxiliary layer structure (3, 4) and to form an isotropically patterned first auxiliary layer structure (2B);
f) forming a mask layer (5) over the entire surface, including at the subsections (TA) beneath the second auxiliary layer structure (3, 4);
g) anisotropically etching the mask layer (5) down to the carrier layer (1) to form the sublithographic structures (5A); and
h) removing the first and second auxiliary layer structures (2B, 3, 4) to uncover the sublithographic structures (5A),
**characterized in that**
in step c), as the second auxiliary layer structure (3, 4), a second auxiliary layer is formed over the entire surface and is lithographically patterned to form at least two lithographic auxiliary layer structures (3), and
a spacer layer is formed over the entire surface and is patterned by means of a spacer process through an isotropic etchback to form a spacer structure (4).

2. Process according to Patent Claim 1, **characterized in that**
in step c) a distance between two adjacent second auxiliary layer structures (3, 4) is set by the spacer structure (4) to half the width of the lithographic auxiliary layer structure (3), and
in step e) a width of the subsections (TA) is likewise set to half the width of the lithographic auxiliary layer structure (3).

3. Process according to Patent Claim 2, **characterized in that**
in step b) a thickness of the first auxiliary layer (2) is set to be less than 1/4 of the respective width of the at least two lithographic auxiliary layer structures (3).

4. Method according to one of Patent Claims 1 to 3, **characterized in that**
Si is used as carrier layer (1);
SiGe, C or SILK^{™}, which is an organic spin-on polymer, is used as first auxiliary layer (2);
SiN is used as second auxiliary layer structure (3, 4); and
SiO₂ is used as mask layer (5).

5. Process according to one of Patent Claims 1 to 3, **characterized in that**
SiO₂ is used as carrier layer (1);
SiGe, C or SILK^{™}, which is an organic spin-on polymer, is used as first auxiliary layer (2);
SiN is used as second auxiliary layer structure (3, 4); and
Si is used as mask layer (5).

6. Process according to either of Patent Claims 4 and 5, **characterized in that**
SiGe is used as first auxiliary layer (2), and in steps e) and h) the first auxiliary layer (2) is removed using HNO₃/HF/CH₃COH/H₂O or H₂O₂ or NH₄OH/H₂O₂/H₂O as etchant; and
in step h) the second auxiliary layer structure is removed using H₃PO₄ as etchant.

7. Process according to one of Patent Claims 1 to 6, **characterized in that** the respective width of the at least two lithographic auxiliary layer structures (3) is a minimum feature size (F) that can be produced by means of lithography.

## Revendications

1. Procédé de production de structures sublithographiques comprenant les stades dans lesquels :
a) on prépare une couche (1) de support ;
b) on forme une première couche (2) auxiliaire sur toute la surface à la surface de la couche (1) de support ;
c) on forme une deuxième structure (3, 4) de couche auxiliaire structurée lithographiquement à la surface de la première couche (2) auxiliaire ;
d) on attaque de façon anisotrope la première couche (2) auxiliaire en utilisant la deuxième structure (3, 4) de couche auxiliaire structurée comme masque, jusqu'à la couche (1) de support pour former une première structure (2A) de couche structurée ;
e) on attaque en retrait de façon isotrope la première structure (2A) de couche auxiliaire structurée de façon anisotrope, en utilisant la deuxième structure (3, 4) de couche auxiliaire structurée pour éliminer des sous-parties (TA) en dessous de la deuxième structure (3, 4) de couche auxiliaire et pour former une première structure (2B) de couche auxiliaire structurée de manière isotrope ;
f) on forme une couche (5) de masque sur toute la surface également sur les sous-parties (TA) en dessous de la deuxième structure (3, 4) de couche auxiliaire ;
g) on attaque de façon isotrope la couche (5) de masque jusqu'à la couche (1) de support pour former les structures (5A) sublithographiques ; et
h) on élimine la première et la deuxième structures (2B, 3, 4) de couche auxiliaire pour mettre à nu les structures (5A) sublithographiques,
**caractérisé en ce que** au stade c) on forme comme deuxième structure (3, 4) de couche auxiliaire une deuxième couche auxiliaire sur toute la surface et, pour former au moins deux structures (3) lithographiques de couche auxiliaire, on la structure lithographiquement , et
on forme sur toute la surface une couche d'espaceur et, pour former une structure (4) d'espaceur, on la structure par attaque en retrait anisotrope au moyen d'un procédé d'espaceur.

2. Procédé suivant la revendication 1, **caractérisé en ce que**
au stade c) on établit une distance entre deux deuxièmes structures (3, 4) de couche auxiliaire voisines par la structure (4) d'espaceur à une demi-largeur de la structure (3) de couche auxiliaire lithographique, et
au stade e) on établit une largeur des sous-parties (TA) également à une demi-largeur de la structure (3) de couche auxiliaire lithographique.

3. Procédé suivant la revendication 2,
**caractérisé en ce que**
au stade b) on établit une épaisseur de la première couche (2) auxiliaire d'un quart de la largeur respective des au moins deux structures (3) de couche auxiliaire lithographique.

4. Procédé suivant l'une des revendications 1 à 3,
**caractérisé en ce que**
on utilise
comme couche (1) de support du Si ;
comme première couche (2) auxiliaire du SiGe, du C ou du SILK (marque de fabrique) qui est un polymère organique spin-on ;
comme deuxième structure (3, 4) de couche auxiliaire du SiN ; et
comme couche (5) de masque du SiO₂.

5. Procédé suivant la revendication 1 à 3, **caractérisé en ce que** l'on utilise
comme couche (1) de support du SiO₂ ;
comme première couche (2) auxiliaire du SiGe, du C ou du SILK (marque de fabrique) (qui est un polymère organique spin-on)
comme deuxième structure (3, 4) auxiliaire du SiN ; et
comme couche (5) de masque du Si.

6. Procédé suivant l'une des revendications 4 ou 5, **caractérisé en ce que** l'on utilise
comme première couche (2) auxiliaire du SiGe et on élimine dans les stades e) et h) la première couche (2) auxiliaire par du HNO₃/HF/CH₃COH/H₂O ou par du H₂O₂ ou par du NH₄OH/H₂O₂/H₂O comme agent d'attaque ; et
au stade h) on élimine la deuxième structure de couche auxiliaire par du H₃PO₄ comme agent d'attaque.

7. Procédé suivant l'une des revendications 1 à 6, **caractérisé en ce que** la largeur respective des au moins deux structures (3) de couche auxiliaire lithographiques a une dimension (F) de structure minimale pouvant être produite au moyen d'une lithographie.
